# DEMANDE DE BREVET EUROPEEN

(11) **EP 2 412 523 A1**
(43) Date de publication de la demande: **01.02.2012**
(21) Numéro de dépôt: 11177003.8
(22) Date de dépôt: 25.01.2007
(51) Int. Cl.: B32B 27/08, B32B 27/30, B32B 7/12, C08L 27/16, C08L 33/12, H01L 31/048, B29D 7/01, F24J 2/50

(54) **Film flexible à base de polymere fluoré**

(30) Priorité: 25.01.2006 FR 0600695
(62) Demande divisionnaire de: 07731521.6
(71) Demandeur: Arkema France, 92700 Colombes (FR)
(72) Inventeur: Bonnet, Anthony, 69720 Saint Laurent de Mure (FR); Duc, Sandrine, 13800 ISTRES (FR); Mathieu, Cyrille, 76000 ROUEN (FR); Laffargue, Johann, 27300 PLASNES (FR)
(74) Mandataire: Lhoste, Catherine

(57) **Abrégé**

L'invention est relative à une structure multicouche comprenant
• un film à base de PVDF F1 accolé à une feuille de PET ou de PEN ou bien
• un film à base de PVDF F1 accolé à une feuille de PET ou de PEN elle-même accolée à un film à base de PVDF F2,

le film F1 et/ou F2 comprenant (dans l'ordre en partant de la feuille de PET ou de PEN) :
• une couche de composition A, consistant en 50 à 70 parties de PVDF homopolymère, de 10 à 40 parties d'au moins un PMMA et de 10 à 25 parties d'au moins une charge minérale, le total faisant 100 parties ;
• éventuellement une couche de composition C comprenant de 80 à 100 parties d'au moins un PVDF, de 0 à 20 parties d'au moins un PMMA, de 0 à 30 parties d'au moins une charge minérale et de 0 à 3 parties d'au moins un agent dispersant, le total faisant 100 parties ;

tel qu'une couche adhésive est disposée entre la feuille de PET ou de PEN et le film F1 et/ou F2.

## Description

### [Domaine de l'invention]

La présente invention concerne un film à base de PVDF pour la protection de substrats et les substrats recouverts par ce film. Elle concerne aussi une structure multicouche associant une feuille de PET ou de PEN et le film à base de PVDF. Enfin, l'invention concerne les utilisations du film à base de PVDF ou du film multicouche, notamment pour la protection des modules photovoltaïques.

### [Le problème technique]

Le PVDF (polyfluorure de vinylidène) en raison de sa très bonne résistance aux intempéries, au rayonnement et aux produits chimiques est un polymère utile pour protéger les objets et matériaux. Il est aussi apprécié pour son aspect brillant et sa résistance aux graffitis. On est donc amené à revêtir toutes sortes d'objets avec un film de PVDF. Cependant, il est nécessaire que le film présente une bonne adhérence sur le substrat à protéger, présente une très bonne résistance thermique que demandent les applications extérieures soumises à des conditions climatiques sévères ou les procédés de transformation réalisés à haute température. Il est nécessaire aussi que le film présente une bonne flexibilité et une bonne résistance à la rupture de façon à résister aux sollicitations mécaniques lors de la pose du film sur l'objet ou une fois le film posé sur l'objet lorsque ce dernier est mis en forme, par exemple par emboutissage. Un test applicatif utilisé consiste à déchirer un film qui a subi un vieillissement en étuve et à voir si la déchirure se propage facilement ou pas.

La Demanderesse a mis au point un film à base de PVDF qui présente une bonne flexibilité et une bonne résistance à la rupture, qui est utilisablecertaines applications. Elle a aussi mis au point une structure multicouche associant le film à base de PVDF à une feuille de PET ou de PEN.

### [L'art antérieur]

La demande EP 1382640 décrit un film à deux ou trois couches à base d'un PVDF homo- ou copolymère. Le PVDF copolymère comprend de 0 à 50% de comonomère. Les exemples décrivent l'utilisation de PVDF homopolymère.

La demande EP 1566408 décrit un film à deux ou trois couches à base de PVDF homo- ou copolymère. Le PVDF copolymère comprend de 0 à 50% de comonomère, avantageusement de 0 à 25% et de préférence de 0 à 15%. Le film ne contient aucune charge.

La demande EP 172864 décrit une cellule photovoltaïque protégée par un film PVDF / PET. Il n'y a pas de couche adhésive entre le PVDF et le PET.

La demande internationale WO 2005/081859 décrit des films multicouches à base de polymère fluoré et de polymère acrylique.

Le brevet US 6555190 décrit une structure multicouche associant dans l'ordre une couche de PEN, une couche adhésive et une couche d'un polymère fluoré (PCTFE, PVDF, ...). La couche adhésive comprend une polyoléfine fonctionnalisée par un acide carboxylique ou un anhydride insaturé ou bien un homo- ou copolymère comprenant comme monomère(s) l'acide acrylique, les acrylates et acrylates d'alkyle éventuellement modifié par un acide ou anhydride insaturé.

La demande US 2005/0268961 décrit un module photovoltaïque protégé par un film comprenant deux couches de polymère fluoré, l'une ayant une température de fusion supérieure à 135°C, l'autre ayant une température de fusion inférieure à 135°C.

La demande US 2005/0172997 ou le brevet US 6369316 décrivent un module photovoltaïque protégé par un film en poly(fluorure de vinyle) (film TEDLAR).

### [Figures]

La figure 1 représente un ensemble 1 comprenant un module photovoltaïque 2 protégé par 3.
La figure 2 représente de façon schématique un ensemble 4 comprenant un module photovoltaïque 2 protégé par le film 3. Le module 2 comprend une couche 6 constituée de cellules photovoltaïques enrobées dans une résine thermoplastique (par ex. en EVA). Le module 2 comprend aussi une plaque de verre 5 servant de support avant du module 2. La protection est assurée par une structure multicouche 3 comprenant une feuille de PET 8 disposée entre deux films à base de PVDF, référencés 7 et 7'.
La figure 3 représente une pièce emboutie 9 (sous la forme schématique d'un godet) constituée d'une tôle en acier 10 protégé par un film à base de PVDF, référencé 11.

### [Brève description de l'invention]

L'invention est relative à une structure multicouche utilisant un film à base de PVDF telle que définie à la revendication 1. L'invention est relative aussi aux utilisations deladite structure et au procédé de fabrication d'un film à base de PVDF.

La demande française FR 06.00695 dont la priorité du 25 janvier 2006 est revendiquée est intégralement incorporée à la présente demande.

### [Description détaillée]

**S'agissant du PVDF**, on désigne ainsi les PVDF, homopolymères du fluorure de vinylidène (VDF, CH₂=CF₂) et les copolymères du VDF contenant de préférence au moins 50 % en poids de VDF et au moins un autre monomère fluoré copolymérisable avec le VDF. De préférence, le PVDF contient, en poids, au moins 50% de VDF, plus préférentiellement au moins 75% et mieux encore au moins 85%.

De préférence, afin de favoriser la flexibilité du film, on pourra utiliser pour l'une quelconque des couches du film, un PVDF comprenant avantageusement en poids de 5 à 20%, avantageusement de 7 à 13% d'au moins un comonomère fluoré pour 80 à 95% de VDF, avantageusement pour 87 à 93% de VDF (on désigne par la suite ce type de PVDF par « PVDF flexible »). De préférence, on utilise le PVDF flexible pour les compositions A et B.

Avantageusement, le comonomère fluoré copolymérisable avec le VDF est choisi par exemple parmi le fluorure de vinyle; le trifluoroéthylène (VF3); le chlorotrifluoroethylène (CTFE); le 1,2-difluoroéthylène; le tetrafluoroéthylène (TFE); l'hexafluoropropylène (HFP); les perfluoro(alkyl vinyl) éthers tels que le perfluoro(méthyl vinyl)éther (PMVE), le perfluoro(éthyl vinyl) éther (PEVE) et le perfluoro(propyl vinyl) éther (PPVE); le perfluoro(1,3-dioxole); le perfluoro(2,2-diméthyl-1,3-dioxole) (PDD).

De préférence le comonomère fluoré est choisi parmi le chlorotrifluoroéthylène (CTFE), l'hexafluoropropylène (HFP), le trifluoroéthylène (VF3) et le tétrafluoroéthylène (TFE). Le comonomère est avantageusement l'HFP car il copolymérise bien avec le VDF et permet d'apporter de bonnes propriétés thermomécaniques. De préférence, le copolymère ne comprend que du VDF et de l'HFP.

Avantageusement, le PVDF a une viscosité allant de 100 Pa.s à 2000 Pa.s, la viscosité étant mesurée à 230°C, à un gradient de cisaillement de 100 s⁻¹ à l'aide d'un rhéomètre capillaire. En effet, ce type de PVDF est bien adapté à l'extrusion. De préférence, le PVDF a une viscosité allant de 300 Pa.s à 1200 Pa.s, la viscosité étant mesurée à 230°C, à un gradient de cisaillement de 100 s⁻¹ à l'aide d'un rhéomètre capillaire.

**S'agissant du PMMA**, on désigne ainsi les homopolymères du méthacrylate de méthyle (MMA) et les copolymères contenant au moins 50% en poids de MMA et au moins un autre monomère copolymérisable avec le MMA.

A titre d'exemple de comonomère copolymérisable avec le MMA, on peut citer par exemple les (méth)acrylates d'alkyle, l'acrylonitrile, le butadiène, le styrène, l'isoprène. Des exemples de (méth)acrylates d'alkyle sont décrits dans KIRK-OTHMER, Encyclopedia of chemical technology, 4ème édition dans le Vol. 1 pages 292-293 et dans le Vol. 16 pages 475-478.

Avantageusement, le PMMA comprend en poids de 0 à 20% et de préférence 5 à 15% d'un (méth)acrylate d'alkyle en C₁-C₈, qui est de préférence l'acrylate de méthyle et/ou l'acrylate d'éthyle. Le PMMA peut être fonctionnalisé c'est-à-dire qu'il contient par exemple des fonctions acide, chlorure d'acide, alcool, anhydride. Ces fonctions peuvent être introduites par greffage ou par copolymérisation. Avantageusement, c'est une fonction acide apportée par le comonomère acide acrylique. Deux fonctions acide acrylique voisines peuvent se déshydrater pour former un anhydride. La proportion de fonctions peut être de 0 à 15% en poids du PMMA comprenant les fonctions éventuelles.

Le PMMA peut comprendre éventuellement au moins un élastomère acrylique mais il est préférable d'éviter d'utiliser un tel PMMA car l'élastomère acrylique peut induire un blanchiment du film. Il existe des qualités commerciales de PMMA dites « choc » qui contiennent un élastomère acrylique sous forme de particules multicouches. L'élastomère acrylique est alors présent dans le PMMA tel qu'il est commercialisé (c'est-à-dire introduit dans la résine au cours du procédé de fabrication) mais il peut aussi être ajouté lors de la fabrication du film. La proportion d'élastomère acrylique varie de 0 à 30 parts pour 70 à 100 parts de PMMA, le total faisant 100 parts. Les particules multicouches, appelées aussi couramment core-shell (noyau-écorce), peuvent être utilisées comme élastomère acrylique, elles comprennent au moins une couche élastomérique (ou molle), c'est-à-dire une couche formée d'un polymère ayant une température de transition vitreuse (Tg) inférieure à -5°C et au moins une couche rigide (ou dure), c'est-à-dire formée d'un polymère ayant une Tg supérieure à 25°C. La taille des particules est en général inférieure au µm et avantageusement comprise entre 50 et 300 nm. On trouvera des exemples de particules multicouches de type core-shell dans les documents suivants : EP 1061100 A1**,** US 2004/0030046 A1**,** FR-A-2446296 **ou** US 2005/0124761 A1**.** On préfèrera des particules ayant au moins 80% en poids de phase élastomérique molle. L'élastomère acrylique a pour fonction d'améliorer la résistance en traction du PMMA (modifiant choc) et de favoriser la souplesse du PMMA.

Le MVI (melt volume index ou indice de fluidité en volume à l'état fondu) du PMMA peut être compris entre 2 et 15 cm³/10 min mesuré à 230°C sous une charge de 3,8 kg.

**S'agissant de la couche adhésive**, celle-ci permet de faire adhérer le film sur le substrat et est constituée de tout type d'adhésif permettant de faire adhérer le film sur le substrat. On peut utiliser pour la couche adhésive les colles uréthanes (colle PU), époxydes, acryliques ou polyesters qu'elles soient sous forme thermoplastique ou thermodurcissable. Avantageusement, on pourra utiliser une colle PU.

**S'agissant de l'absorbeur UV**, il peut s'agir par exemple des additifs cités dans le brevet US 5256472. On utilise avantageusement les composés de type benzotriazoles, benzophénones, benzylidène malonates ou quinazolines. A titre d'exemple on peut utiliser les TINUVIN^{®} 213 ou TINUVIN^{®} 109 et de façon préférable le TINUVIN^{®} 234 de la société Ciba Speciality Chemicals.

**S'agissant de l'agent dispersant**, il a pour fonction d'aider à disperser la charge minérale. Il s'agit de préférence d'un polyalkylène glycol, c'est-à-dire d'un polymère renfermant des motifs oxyde d'alkylène (par ex. oxyde d'éthylène ou de propylène). De préférence, il s'agit du poly(oxyéthylène)glycol appelé communément polyéthylène glycol (PEG). Le polyalkylène glycol a de préférence une masse moyenne en nombre comprise entre 1000 et 10000 g/mol. Le polyalkylène glycol permet d'enrober les particules de la charge minérale et d'éviter un contact direct entre les particules et le PVDF.

Des exemples de PEG sont décrits dans les brevets US 5587429 et US 5015693**.** Ainsi, on peut citer : le polyéthylène glycol de formule H(OC₂H₄)ₙOH où n est un entier proche de 76, compris entre 70 et 80 ; le produit de formule H(OC₂H₄)_{d}[OCH(CH₃)CH₂]ₑ(OC₂H₄)_{f}OH où d, e et f désignent des entiers avec d+f est proche de 108, compris entre 100 et 110, et e proche de 35, entre 30 et 40 ; le CARBOWAX^{®} 3350 ayant une masse moléculaire moyenne en nombre d'environ 3500 g/mol ; le CARBOWAX^{®} 8000 ayant une masse moléculaire moyenne en nombre d'environ 8000 g/mol ; le POLYGLYCOL^{®} 8000 de CLARIANT ayant une masse moléculaire moyenne en nombre comprise entre 7000 et 9000 g/mol.

**S'agissant de la charge minérale**, il peut s'agir d'un oxyde métallique comme par exemple le dioxyde de titane (TiO₂), la silice, le quartz, l'alumine, d'un carbonate comme par exemple le carbonate de calcium, le talc, le mica, la dolominte (CaCO ₃•MgCO₃), la montmorillonite (aluminosilicate), BaSO₄, ZrSiO₄, Fe₃O₄.

La charge minérale a une fonction d'opacifiant dans le domaine de l'UV/visible. L'action protectrice de la charge est complémentaire de celle de l'absorbeur UV. De plus, à la différence de l'absorbeur UV qui est une molécule organique, la charge minérale opacifiante conserve une action protectrice plus longtemps (elle n'est pas dégradée). Une charge de TiO₂ est tout particulièrement préférée de ce point de vue-là.

La charge minérale peut avoir une autre fonction. Par exemple, il peut s'agir d'une charge ignifugeante, comme par exemple l'oxyde d'antimoine (Sb₂O₃, Sb₂O₅) Al(OH)₃, Mg(OH)₂, la huntite (3MgCO₃•CaCO₃), l'hydromagnésite (3MgCO₃• Mg(OH)₂•3H₂O). Il peut s'agir aussi d'une charge conductrice de l'électricité (par exemple, du noir de carbone ou bien des nanotubes de carbone).

La charge a une taille généralement comprise entre 0,05 µm et 1 mm. De préférence, la teneur en charge minérale dans la composition A ou C est comprise entre 0,1 et 30 parties (pour un total de 100 parties). Avantageusement, la teneur varie entre 10 et 25 parties, de préférence entre 10 et 20 parties. Il est préférable que la teneur en charge minérale soit d'au moins 10 parties pour observer une bonne efficacité de la charge opacifiante (et éventuellement ignifugeante). Il est préférable aussi que cette teneur ne dépasse pas 25 parties, voire 20 parties, pour ne pas dégrader les propriétés mécaniques de la couche qui comprend la charge, donc les propriétés mécaniques du film tout entier.

**S'agissant du film à base de PVDF**, celui-ci se présente sous plusieurs formes.

### 1^{ère} forme

Selon une 1^{ère} forme, le film à base de PVDF comprend de 50 à 100 parties d'au moins un PVDF, de 0 à 50 parties d'au moins un PMMA, de 0 à 30 parties d'au moins une charge minérale et de 0 à 3 parties d'au moins un agent dispersant, le total faisant 100 parties (composition A). Le film adhère sur le substrat à l'aide d'une couche adhésive, qui peut être par exemple une couche d'une colle polyuréthane (PU). On a donc une structure multicouche comprenant dans l'ordre :
le substrat / une couche adhésive / une couche de composition A

### best mode

La composition A comprend de 50 à 70 parties d'au moins un PVDF, de 10 à 40 parties d'au moins un PMMA et de 10 à 25 parties d'au moins une charge minérale (de préférence le TiO₂), le total faisant 100 parties. Exemple: 60% PVDF flexible + 15% TiO₂ + 25% PMMA (voir exemple 1).

De préférence, le PVDF de la composition A est un PVDF flexible.

### 2^{ème} forme

Selon une 2^{ème} forme, le film à base de PVDF comprend une couche de composition A et une couche de composition B comprenant de 5 à 40 parties d'au moins un PVDF, de 60 à 95 parties d'au moins un PMMA et de 0 à 5 parties d'au moins un absorbeur UV, le total faisant 100 parties. Le film adhère sur le substrat soit à l'aide de la composition B soit à l'aide d'une couche adhésive disposée entre le substrat et la couche de composition B. On a donc une structure multicouche comprenant dans l'ordre :
le substrat / éventuellement une couche adhésive / une couche de composition B / une couche de composition A

De préférence, le PVDF de la composition B est un PVDF flexible. De préférence, la composition B ne contient aucun élastomère acrylique ni aucune particule noyau-écorce.

### 3^{ème} forme

Selon une 3^{ème} forme, le film à base de PVDF comprend une couche de composition C comprenant de 80 à 100 parties d'au moins un PVDF, de 0 à 20 parties d'au moins un PMMA, de 0 à 30 parties d'au moins une charge minérale et de 0 à 3 parties d'au moins un agent dispersant, le total faisant 100 parties et une couche de composition A. Le film adhère sur le substrat à l'aide d'une couche adhésive. On a donc une structure multicouche comprenant dans l'ordre :
le substrat / une couche adhésive / une couche de composition A / une couche de composition C

### best mode

La composition C ne comprend comme polymère que du PVDF. La composition A comprend de 50 à 70 parties d'au moins un PVDF, de 10 à 40 parties d'au moins un PMMA et de 10 à 25 parties d'au moins une charge minérale (de préférence le TiO₂), le total faisant 100 parties. Exemple: [60% PVDF flexible + 15% TiO₂ + 25% PMMA] / PVDF homopolymère (voir exemple 3).

De préférence, le PVDF de la composition C est un PVDF homopolymère. De préférence, le PVDF de la composition A est un PVDF flexible.

### 4^{ème} forme

Selon une 4^{ème} forme, le film à base de PVDF comprend une couche de composition C, une couche de composition A et une couche de composition B. Le film adhère sur le substrat soit à l'aide de la composition B soit à l'aide d'une couche adhésive. On a donc une structure multicouche comprenant dans l'ordre :
le substrat / éventuellement une couche adhésive / une couche de composition B / une couche de composition A / une couche de composition C

### best mode

La composition C ne comprend comme polymère que le PVDF. La composition B comprend de 5 à 40 parties d'au moins un PVDF, de 60 à 95 parties d'au moins un PMMA et de 0 à 5 parties d'au moins un absorbeur UV, le total faisant 100 parties. La composition A comprend de 50 à 70 parties d'au moins un PVDF, de 10 à 40 parties d'au moins un PMMA et de 10 à 25 parties d'au moins une charge minérale (de préférence le TiO₂), le total faisant 100 parties.

De préférence, le PVDF de la composition C est un PVDF homopolymère. De préférence, le PVDF de la composition A et/ou B est un PVDF flexible.

Dans les 3^{ème} et 4^{ème} formes, la couche de composition C, qui est disposée contre la couche de composition A, est donc la couche la plus « externe ». Pour toutes les formes, la composition A et/ou B ne contient de préférence aucun élastomère acrylique ni aucune particule noyau-écorce. En effet, ceci peut induire un blanchiment du film lorsque ce dernier est soumis à une déformation importante, ce qui est le cas par exemple lors de la fabrication du film soit lors de la mise en place du film sur le substrat (par exemple lors de l'emboutissage d'une feuille de métal protégée par le film).

Le film à base de PVDF qui protège le substrat comprend donc dans l'ordre à partir du substrat une couche de composition B éventuelle, une couche de composition A, une couche de composition C éventuelle, le film adhérant sur le substrat par une couche adhésive et si la couche de composition B est présente, la couche adhésive est optionnelle. Pour chacune des formes de l'invention, l'épaisseur de la couche de composition A est de préférence comprise entre 5 et 50 µm, de préférence entre 5 et 15 µm. L'épaisseur de la couche de composition B est de préférence comprise entre 5 et 45 µm, de préférence entre 5 et 15 µm. L'épaisseur de la couche de composition C est de préférence comprise entre 2 et 30 µm, de préférence entre 2 et 15 µm.

### Fabrication des films à base de PVDF

Le film à base de PVDF est de préférence fabriqué par la technique de coextrusion, mais il est également possible d'utiliser une technique de mise en oeuvre par voie solvant ou bien en utilisant la technique de plaxage.

Le film à base de PVDF peut aussi être fabriqué par coextrusion-soufflage de gaine (« blown film » en Anglais). Cette technique consiste à extruder, généralement de bas en haut, un polymère thermoplastique à travers une filière annulaire, l'extrudat est simultanément tiré longitudinalement par un dispositif de tirage, habituellement en rouleaux, et gonflé par un volume d'air constant emprisonné entre la filière, le système de tirage et la paroi de la gaine. La gaine gonflée, encore appelée « bulle », est refroidie généralement par un anneau de soufflage d'air à la sortie de la filière. La bulle mise à plat est enroulée, soit sous forme de gaine, soit après découpe en deux films séparés. Dans EP 0278804 A1, on coextrude un polymère fluide semi-cristallin avec une résine thermoplastique qui est incompatible de façon telle qu'après refroidissement et mise à plat de la bulle, on récupère séparément les deux films extrudés par des moyens classiques, tel que par enroulement distinct des films séparés. Dans l'exemple unique, une bulle est constituée d'un film de 25 µm de PVDF coextrudé avec un film de 60 µm de polyéthylène (PE). Dans la description, il est précisé que l'épaisseur du film de PE doit être de préférence 1 à 5 fois l'épaisseur du film de polymère semi-cristallin. Il est écrit aussi qu'il n'est pas exclu de pouvoir coextruder plus de deux films, mais rien n'est précisé sur la nature exacte des films en question. La demande internationale WO 03/039840 décrit un procédé de fabrication d'un film fluoré qui utilise aussi un polymère incompatible, qui peut être un PE, un polystyrène choc, un PVC plastifié et de préférence, un PE basse densité.

Le procédé de fabrication du film par le procédé de coextrusion-soufflage à base de PVDF consiste à coextruder :
a) les différentes couches du film à base de PVDF (de composition A, B, C) ;
b) une couche L1 d'une polyoléfine adjacente à la couche composition A ou à la couche de composition C ;
c) éventuellement une autre couche L2 d'une polyoléfine adjacente à l'ensemble des couches extrudées en a) et b), du côté opposé à la couche extrudée en b),
et après refroidissement du coextrudat, à récupérer, par séparation de la (ou des) couche(s) de polyoléfine, le film à base de PVDF.

La polyoléfine (appelée aussi « liner ») utilisée en b) peut être identique ou différente de celle utilisée en c).

### [Utilisations du film]

On décrit maintenant plus en détails les utilisations du film à base de PVDF.

### comme film protecteur pour module photovoltaïque

Les modules photovoltaïques peuvent être protégés à l'arrière par le film à base de PVDF. Un module photovoltaïque permet de convertir l'énergie lumineuse en courant électrique. Généralement, un module photovoltaïque comprend des cellules photovoltaïques montées en série et reliées entres elles par des moyens de connection électrique. Les cellules photovoltaïques sont généralement mono jonction fabriquées à base de silicium multi-cristallin dopé "P" avec du bore lors de la fusion du silicium et dopées "N" avec du phosphore sur leur surface éclairée. Ces cellules sont mises en place dans un empilage laminé. L'empilage laminé peut être constitué d'EVA (copolymère éthylène-acétate de vinyle) enrobant les cellules photovoltaïques pour protéger le silicium de l'oxydation et de l'humidité. L'empilage est imbriqué entre une plaque de verre qui sert de support d'un côté et il est protégé par un film de l'autre côté. Le module photovoltaïque est ainsi protégé contre le vieillissement (UV, brouillard salin,...), contre les rayures, l'humidité ou la vapeur d'eau

Le module est généralement protégé par une structure multicouche commercialisée sous la marque AKASOL^{®} ou ICOSOLAR^{®} qui est une association d'un film de TEDLAR^{®} (polyfluorure de vinyle ou PVF) et d'une feuille de PET (polyéthylène téréphtalate). La Demanderesse a constaté qu'il est possible d'utiliser avantageusement un film à base de PVDF tel que défini précédemment à la place du film de TEDLAR^{®}. Un avantage est notamment que le PVDF présente une meilleure résistance mécanique et une température de fusion plus élevée (tenue thermique plus élevée) que le PVF. La structure multicouche comprend donc une feuille de PET accolée à au moins un film à base de PVDF tel que défini précédemment et se présente sous la forme :
un film à base de PVDF F1 / une feuille de PET ou sous la forme :
un film à base de PVDF F1 / une feuille de PET / un film à base de PVDF F2

Sous cette 2^{ème} forme, les deux films F1 et F2 sont tels que définis précédemment. Ils peuvent être identiques ou différents, c'est-à-dire être indépendamment l'un de l'autre selon l'une des 4 formes de l'invention décrites précédemment. Chacun des deux films F1 ou F2 adhère sur la feuille de PET à l'aide d'une couche de composition B ou bien à l'aide d'une couche adhésive.

La structure multicouche comprend :
- un film à base de PVDF F1 accolé à une feuille de PET ou de PEN ou bien
- un film à base de PVDF F1 accolé à une feuille de PET ou de PEN elle-même accolée à un film à base de PVDF F2,
le film F1 et/ou F2 comprenant (dans l'ordre en partant de la feuille de PET ou de PEN) :
- éventuellement une couche de composition B comprenant de 5 à 40 parties d'au moins un PVDF, de 60 à 95 parties d'au moins un PMMA et de 0 à 5 parties d'au moins un absorbeur UV, le total faisant 100 parties ;
- une couche de composition A, comprenant de 50 à 100 parties d'au moins un PVDF, de 0 à 50 parties d'au moins un PMMA, de 0 à 30 parties d'au moins une charge minérale et de 0 à 3 parties d'au moins un agent dispersant, le total faisant 100 parties ;
- éventuellement une couche de composition C comprenant de 80 à 100 parties d'au moins un PVDF, de 0 à 20 parties d'au moins un PMMA, de 0 à 30 parties d'au moins une charge minérale et de 0 à 3 parties d'au moins un agent dispersant, le total faisant 100 parties ;
tel :
- qu'une couche adhésive est disposée entre la feuille de PET ou de PEN et le film F1 et/ou F2 ;
- cette couche adhésive étant optionnelle si la couche de composition B est présente.

De préférence, la couche adhésive ne comprend aucune une polyoléfine fonctionnalisée par un acide carboxylique ou un anhydride insaturé ou bien un homo- ou copolymère comprenant comme monomère(s) l'acide acrylique, les acrylates et acrylates d'alkyle éventuellement modifié par un acide ou anhydride insaturé. De préférence aussi, les compositions A et/ou B ne contiennent aucun élastomère acrylique ni aucune particule noyau-écorce.

On a donc dans l'ordre les successions suivantes :
comp. C évent. / comp. A / comp. B évent. / couche adhésive / PET
ou comp. C évent. / comp. A / comp. B évent. / couche adhésive / PET / couche adhésive / comp. B évent. / comp. A / comp. C évent. La couche adhésive est optionnelle si la couche de composition B est présente. Si on utilise une couche adhésive, une colle PU est préférée.

La structure multicouche peut être fabriquée par compression à chaud des différents éléments (c'est-à-dire la feuille de PET, le film(s) à base de PVDF, ...). On peut aussi utiliser la technique de lamination qui consiste à laminer en continu le(s) film(s) à base de PVDF (préalablement sous forme de bobine) avec la feuille de PET sur laquelle on a déposé éventuellement l'adhésif. Un exemple de procédé de lamination sous vide permettant d'appliquer une structure de type AKASOL^{®} ou ICOSOLAR^{®} sur un module photovoltaïque est décrit dans US 5593532 et peut s'appliquer à la structure multicouche de l'invention. Généralement, la structure est donc fabriquée en associant le(s) film(s) à base de PVDF déjà formé(s) avec la feuille de PET. C'est pourquoi on préfère utiliser un adhésif que l'on dépose à l'état liquide du type thermodurcissable plutôt qu'un thermoplastique qui nécessite d'avoir recours à la coextrusion. C'est pourquoi on exclut que la couche adhésive comprenne une polyoléfine fonctionnalisée par un acide carboxylique ou un anhydride insaturé ou bien un homo- ou copolymère comprenant comme monomère(s) l'acide acrylique, les acrylates et acrylates d'alkyle éventuellement modifié par un acide ou anhydride insaturé.

On peut aussi utiliser à la place du PET du PEN (polyéthylène naphtalate) qui présente l'avantage d'avoir une Tg plus élevée que celle du PET. Le PEN possède une excellente résistance UV mais les films de PEN sont cassants (brittle) et ne sont pas barrière à l'humidité.

Les figures 1 et 2 représentent schématiquement des exemples d'un module photovoltaïque 2 protégé. La référence 3 sur la figure 1 représente soit un film à base de PVDF soit une structure multicouche associant une feuille de PET ou de PEN à un ou deux films à base de PVDF.

L'invention se rapporte aussi au module photovoltaïque protégé par le film à base de PVDF ou bien par la structure multicouche. Dans le cas du film à base de PVDF, on a donc l'ordre suivant : (le module) / couche adhésive / comp. B évent. / comp. A / comp. C évent., la couche adhésive étant optionnelle si la couche de composition B est présente.

et dans le cas de la structure multicouche, on a l'ordre suivant :
(le module) / comp. C évent. / comp. A / comp. B évent. / couche adhésive / PET
   ou (le module) / comp. C évent. / comp. A / comp. B évent. / couche adhésive / PET / couche adhésive / comp. B évent. / comp. A / comp. C évent.
   la couche adhésive étant optionnelle si la couche de composition B est présente.

L'invention n'est cependant pas limitée au module photovoltaïque tel qu'il a été décrit plus haut ou sur la figure 2. On trouvera ainsi d'autres exemples de modules photovoltaïques dans FR 2863775 A1 (voir notamment la figure 1), US 6369316 B1**,** US 2004/0229394 A1**,** US 2005/0172997 A1**,** US 2005/0268961 A1**.**

### comme film protecteur de substrats souples

Le film à base de PVDF peut servir à protéger un substrat souple comme par exemple un textile technique qui peut être tissé ou non tissé. Il peut s'agir d'un tissu en PVC, en polyester ou en polyamide, un tissu de verre, un mat de verre, un tissu en aramide ou en Kevlar,.... Une bâche en PVC constitue un exemple de substrat souple en PVC. Le film de l'invention peut être par exemple appliqué sur le tissu technique à l'aide de la technique de lamination ou par enduction.

L'invention se rapporte aussi au textile technique protégé par le film à base de PVDF. On a donc la succession suivante : (le textile technique) / couche adhésive / comp. B évent. / comp. A / comp. C évent., la couche adhésive étant optionnelle si la couche de composition B est présente.

### comme film protecteur d'une feuille de métal

Le film à base de PVDF peut être colaminé sur un substrat en métal qui peut être par exemple l'acier, le cuivre ou l'aluminium. De préférence, il s'agit d'une feuille métallique, de préférence en acier. De préférence, l'acier est galvanisé, et est revêtu ou non d'un primaire. L'acier peut par exemple être traité par le Zincrox ou revêtu par le primaire B1236 acrylique/vinylique, le primaire B710 époxy ou le primaire polyester mélamine CN4118. Le film à base de PVDF est suffisamment flexible pour que l'ensemble acier / film puisse ensuite subir une déformation importante. Par exemple, l'ensemble peut être embouti.

La figure 3 représente un exemple de pièce en acier 10 protégée par le film à base de PVDF, référencé 10. La pièce représente un godet métallique (par exemple en acier) obtenu par emboutissage d'une feuille de métal sur laquelle a été colaminé le film.

L'invention se rapporte aussi au substrat en métal protégé par le film à base de PVDF. On a donc la succession suivante : (le métal) / primaire évent. / couche adhésive / comp. B évent. / comp. A / comp. C évent., la couche adhésive étant optionnelle si la couche de composition B est présente.

### [Exemples]

### Produits utilisés

**PVDF-1** : copolymère VDF/HFP sous forme de granulés (10% HFP en poids) de MVI 1,1 cm³/10 min (230°C, 5 kg), ayant une viscosité de 2500 mPa s à 230°C, 100 s⁻¹ et une température de fusion d'environ 145°C.

**ALTUGLAS^{®} BS 580 (auparavant vendu sous le nom OROGLAS^{®} BS8) :** PMMA de la société ALTUGLAS INTERNATIONAL (anciennement ATOGLAS) de MVI 4,5 cm³/10 min (230°C, 3,8 kg) sous forme de perle contenant un comonomère, l'acrylate de méthyle à hauteur de 6% en poids. Ce PMMA ne contient pas d'additif choc ni aucun élastomère acrylique.

**PVDF-2** : PVDF homopolymère sous forme de granulés de MVI 1,1 cm³/10 min (230°C, 5 kg).

**PVDF-3** : copolymère VDF/HFP sous forme de granulés (17%poids HFP) de MVI 10 cm³/10 min (230°C, 5 kg), ayant une viscosité de 900 mPa s à 230°C, 100 s⁻¹.

**DESMODUR^{®} N-100** : isocyanate aliphatique de CAS N° 28182-81-2 commercialisé par LANXESS.

**FLUORAD^{®} FC-430 :** tensioactif fluoré de la société 3M.

**TONE^{®} 201** : poly(caprolactone) diol commercialisé par Union Carbide (masse moléculaire environ 830 g/mol).

### Exemple 1 (selon l'invention, 1^{ère} forme)

### [60% PVDF flexible + 15% TiO₂ + 25% PMMA]_{couche A} / colle PU / PET

Un film monocouche constitué en poids de 60% de PVDF-1, de 15% de TiO₂ de référence R960 et de 25 % d'ALTUGLAS^{®} BS 580 est extrudé sous forme d'un film d'épaisseur 15 µm et de largeur 2000 mm à l'aide d'une extrudeuse film à une température de 245°C.

Un substrat polyester (PET) sur lequel a été déposé préalablement un adhésif de la famille des uréthanes, obtenu en faisant réagir 100 parts de TONE^{®} 201, 0,5 part de DBTL (dibutyle ter dilaurate) à 1% dans le xylol, 60 parts d'acétate de propylène glycol méthyle éther, 0,6 parts de FC-430 à 10% (tensioactif fluoré) et de 74 parts de DESMODUR N-100 est passé dans un four pendant 5 minutes à 120°C.

Le film monocouche est ensuite laminé à 130°C sur le substrat polyester (on obtient donc une structure PET / colle PU / film monocouche). L'adhésion obtenue est supérieure à 40 N/cm. Après un passage de 8 heures à l'étuve à 95°C l'adhésion est conservée, la structure peut être pliée facilement sans pour autant générer de fissure au niveau du film fluoré.

### Exemple 2 (selon l'invention, 3^{ème} forme)

### [PVDF homopolymère]_{couche C} / [60% PVDF flexible + 15% TiO₂ + 25% PMMA]_{couche A} / colle PU / PET

Un film à deux couches est constitué :
- d'une couche de 15 µm d'épaisseur contenant en poids 60% de PVDF-1, 15% de TiO₂ de référence R960 et 25% de PMMA d'ALTUGLAS^{®} BS 580, et
- d'une couche de 10 µm d'épaisseur contenant du PVDF-2 (100%) et de largeur 2000 mm est réalisé sur une extrudeuse film à une température de 245°C.

Un substrat polyester (PET) sur lequel a été déposé préalablement un adhésif de la famille des uréthanes, obtenu en faisant réagir 100 parts de TONE^{®} 201, 0,5 part de DBTL (dibutyle ter dilaurate) à 1% dans le xylol, 60 parts d'acétate de propylène glycol méthyle éther, 0,6 parts de FC-430 à 10% en poids (tensioactif fluoré) et de 74 parts de DESMODUR N-100 est passé dans un four pendant 5 minutes à 120°C. Le film bicouche est ensuite laminé à 150°C sur le substrat polyester (on obtient donc une structure PET / colle PU / couche comprenant le PVDF-1 / couche comprenant le PVDF-2).

L'adhésion obtenue est supérieure à 60 N/cm. Après un passage de 8 heures à l'étuve à 95°C, l'adhésion est conservée, la structure peut être pliée facilement sans pour autant générer de fissure au niveau du film fluoré.

### Exemple 3 (selon l'invention, 1^{ère} forme)

### [83% PVDF flexible + 15% Sb₂O₃ + 2% PEG]_{couche A} / colle PU / PET

Un film monocouche constitué en poids de 83% de PVDF-3, de 15% de Sb₂O₃ et de 2% d'un PEG de masse 1500 g/mol de la société CLARIANT, est extrudé sous forme d'un film d'épaisseur 15 µm et de largeur 2000 mm à l'aide d'une extrudeuse film à une température de 245°C.

Un substrat polyester (PET) sur lequel a été déposé préalablement un adhésif de la famille des uréthanes, obtenu en faisant réagir 100 parts de TONE^{®} 201, 0,5 part de DBTL (dibutyle ter dilaurate) à 1% dans le xylol, 60 parts d'acétate de propylène glycol méthyle éther, 0,6 parts de FC-430 à 10% (tensioactif fluoré) et de 74 parts de DESMODUR N-100 est passé dans un four pendant 5 minutes à 120°C.

Le film monocouche est ensuite laminé à 130°C sur le substrat polyester (on obtient donc une structure PET / colle PU / film monocouche). L'adhésion obtenue est supérieure à 40 N/cm. Après un passage de 8 heures à l'étuve à 95°C, l'adhésion est conservée, la structure peut être pliée facilement sans pour autant générer de fissure au niveau du film fluoré. Ce film présente de plus une excellente résistance au feu.

### Exemple 4 (selon l'invention, 1^{ère} forme)

Cet exemple illustre la préparation d'un film monocouche à base de PVDF par la technique de coextrusion-soufflage. Une structure à deux couches est constituée :
- d'une couche de 15 µm d'épaisseur constituée en poids de 83% de PVDF-3, de 15% de Sb₂O₃ et de 2% d'un PEG de masse 1500 g/mol de la société CLARIANT et
- d'une couche de 50 µm d'épaisseur d'un polyéthylène LACQTENE 1003FE23 (MFI=0,3 g/10 min selon ISO 1133et de densité 0,923 selon ISO 1183) commercialisé par TOTAL PETROCHEMICALS
et est réalisée sur une extrudeuse blown film KIEFEL à une température de 245°C. Aucune adhésion n'est générée entre les deux couches. La couche de PE est la couche L1 décrite précédemment (« liner »).

Un substrat polyester (PET) sur lequel a été déposé préalablement un adhésif de la famille des uréthanes, obtenu en faisant réagir 100 parts de TONE^{®} 201, 0,5 part de DBTL (dibutyle ter dilaurate) à 1% dans le xylol, 60 parts d'acétate de propylène glycol méthyle éther, 0,6 parts de FC-430 à 10% (tensioactif fluoré) et de 74 parts de DESMODUR N-100 est passé dans un four pendant 5 minutes à 120°C.

La structure à deux couches est ensuite laminée à 130°C sur le substrat polyester, la couche en contact avec la colle PU étant celle contenant le PVDF-3. Pendant et après la phase de lamination, on obtient ainsi un complexe PET/colle PU/ film monocouche contenant le PVDF-3, et protégée par la couche de PE qui peut ensuite être retirée simplement avant l'utilisation du complexe.

L'adhésion obtenue entre le PET et le film à base de PVDF est supérieure à 40 N/cm. Après un passage de 8 heures à l'étuve à 95°C, l'adhésion est conservée, la structure peut être pliée facilement sans pour autant générer de fissure au niveau du film fluoré. Ce film présente de plus une excellente résistance au feu.

## Revendications

1. Structure multicouche comprenant
• un film à base de PVDF F1 accolé à une feuille de PET ou de PEN ou bien
• un film à base de PVDF F1 accolé à une feuille de PET ou de PEN elle-même accolée à un film à base de PVDF F2,
le film F1 et/ou F2 comprenant (dans l'ordre en partant de la feuille de PET ou de PEN) :
• une couche de composition A, consistant en 50 à 70 parties de PVDF homopolymère, de 10 à 40 parties d'au moins un PMMA et de 10 à 25 parties d'au moins une charge minérale, le total faisant 100 parties ;
• éventuellement une couche de composition C comprenant de 80 à 100 parties d'au moins un PVDF, de 0 à 20 parties d'au moins un PMMA, de 0 à 30 parties d'au moins une charge minérale et de 0 à 3 parties d'au moins un agent dispersant, le total faisant 100 parties ;
tel qu'une couche adhésive est disposée entre la feuille de PET ou de PEN et le film F1 et/ou F2.

2. Structure selon la revendication 1 **caractérisée en ce que** le PVDF de la composition C est un PVDF homopolymère.

3. Structure selon l'une des revendications 1 ou 2 **caractérisée en ce que** le PMMA comprend en poids de 0 à 20% et de préférence 5 à 15% d'un (méth)acrylate d'alkyle en C₁-C₈, qui est de préférence l'acrylate de méthyle et/ou l'acrylate d'éthyle.

4. Structure selon l'une quelconque des revendications précédentes **caractérisée en ce que** la couche adhésive éventuelle est constituée d'une colle uréthane, époxyde, acrylique ou polyester.

5. Structure selon l'une quelconque des revendications précédentes **caractérisée en ce que** la charge minérale est :
- un oxyde métallique choisi parmi le dioxyde de titane (TiO₂), la silice, le quartz, l'alumine, ZrSiO₄, Fe₃O₄, l'oxyde d'antimoine (Sb₂O₃, Sb₂O₅), Al(OH)₃, Mg(OH)₂, la huntite (3MgCO₃•CaCO₃) et l'hydromagnésite (3MgCO₃• Mg(OH)₂•3H₂O) ;
- un carbonate choisi parmi le carbonate de calcium, le talc, le mica et la dolominte (CaCO₃•MgCO₃),
- la montmorillonite,
- BaSO₄, et
- les charges conductrices de l'électricité choisies parmi le noir de carbone et les nanotubes de carbone.

6. Utilisation d'une structure multicouche telle que définie à l'une quelconque des revendications 1 à 5 pour protéger un module photovoltaïque, la structure multicouche étant disposée sur le module par le film à base de PVDF F1.

7. Utilisation selon la revendication 6 dans laquelle ladite charge est le noir de carbone.

8. Utilisation d'un film à base de PVDF pour protéger un substrat qui peut être :
• un module photovoltaïque,
• un textile technique,
• un métal.
le film à base de PVDF comprenant (dans l'ordre en partant du substrat) :
• une couche de composition A, consistant en 50 à 70 parties de PVDF homopolymère, de 10 à 40 parties d'au moins un PMMA et de 10 à 25 parties d'au moins une charge minérale, le total faisant 100 parties ;
• éventuellement une couche de composition C comprenant de 80 à 100 parties d'au moins un PVDF, de 0 à 20 parties d'au moins un PMMA, de 0 à 30 parties d'au moins une charge minérale et de 0 à 3 parties d'au moins un agent dispersant, le total faisant 100 parties ;
et tel qu'une couche adhésive est disposée entre le substrat et le film à base de PVDF.

9. Utilisation selon la revendication 8 dans laquelle le PVDF de la composition C est un PVDF homopolymère.

10. Utilisation selon l'une des revendications 8 ou 9 dans laquelle le PMMA comprend en poids de 0 à 20% et de préférence 5 à 15% d'un (méth)acrylate d'alkyle en C₁-C₈, qui est de préférence l'acrylate de méthyle et/ou l'acrylate d'éthyle.

11. Utilisation selon l'une des revendications 8 à 10 dans laquelle le textile technique un tissé ou un non-tissé.

12. Utilisation selon l'une quelconque des revendications 8 à 11 **caractérisée en ce que** le textile est en PVC, en polyester ou en polyamide, un tissu de verre, un mat de verre, un tissu en aramide ou en Kevlar

13. Module photovoltaïque protégé en surface par une structure multicouche selon l'une quelconque des revendications 1 à 5.

14. Procédé de fabrication d'un film à base de PVDF entrant dans la constitution d'une structure multicouche telle que définie à l'une quelconque des revendications 1 à 5 consistant à coextruder :
a) les différentes couches du film à base de PVDF (de composition A ou C) ;
b) une couche L1 d'une polyoléfine adjacente à la couche composition A ou à la couche de composition C,
c) éventuellement une autre couche L2 d'une polyoléfine adjacente à l'ensemble des couches extrudées en a) et b), du côté opposé à la couche extrudée en b),
et après refroidissement du coextrudat, à récupérer, par séparation de la (ou des) couche(s) de polyoléfine, le film à base de PVDF.
